# FASCICULE DE BREVET EUROPEEN

(11) **EP 4 182 975 B1**
(45) Date de publication et mention de la délivrance du brevet: **09.09.2026**
(21) Numéro de dépôt: 20790038.2
(22) Date de dépôt: 16.07.2020
(51) Int. Cl.: H10H 20/812, H10H 20/821, H10H 29/14

(54) **PROCEDE DE FABRICATION D'UNE LED ET LED REALISEE PAR CE PROCEDE**
VERFAHREN ZUR HERSTELLUNG EINER LED UND NACH DIESEM VERFAHREN HERGESTELLTE LED
METHOD FOR PRODUCING AN LED AND LED PRODUCED BY SAID METHOD

(43) Date de publication de la demande: 24.05.2023
(73) Titulaire: Commissariat à l'Energie Atomique et aux Energies Alternatives, 75015 Paris (FR)
(72) Inventeur: LE MAOULT, Corentin, 38054 Grenoble Cedex 09 (FR); VAUFREY, David, 38054 Grenoble Cedex 09 (FR)
(74) Mandataire: Cabinet Beaumont
(86) Numéro de dépôt international: PCT/FR2020/051276
(87) Numéro de publication internationale: WO 2022/013485

(56) Documents cités:
- WO-A1-2015/099944
- US-A1- 2016 315 218

## Description

### Domaine technique

La présente description concerne de façon générale le domaine des diodes électroluminescentes (LED). Elle vise plus particulièrement la réalisation de LED à base de matériaux semiconducteurs inorganiques.

### Technique antérieure

Divers procédés de fabrication de LED ont été proposés, comme par exemple celui du document US 2016/315218 A.

Il serait souhaitable d'améliorer au moins en partie certains aspects de ces procédés, et des LED obtenues par ces procédés.

On s'intéresse ici plus particulièrement à la passivation des flancs d'un empilement de LED à base de matériaux semiconducteurs inorganiques.

### Résumé de l'invention

Un mode de réalisation prévoit un procédé de fabrication d'une diode électroluminescente selon la revendication 1, comprenant les étapes successives suivantes :
a) former une couche active comportant un empilement de puits quantiques multiples, chaque puits quantique comportant une couche en un alliage semiconducteur ;
b) former une tranchée de singularisation de la diode, ladite tranchée traversant la couche active ; et
c) appliquer sur les flancs de la couche active, au niveau des parois latérales de la tranchée, un traitement chimique adapté à graver un premier composant de l'alliage semiconducteur sélectivement par rapport à au moins un autre composant de l'alliage semiconducteur, dans lequel la largeur de bande interdite de l'alliage semiconducteur est fonction de la concentration du premier composant dans l'alliage.

Selon un mode de réalisation, la largeur de bande interdite de l'alliage semiconducteur est d'autant plus élevée que la concentration du premier composant dans l'alliage est faible.

Selon un mode de réalisation, l'alliage semiconducteur des puits quantiques est un composé III-V ternaire.

Selon un mode de réalisation, l'alliage semiconducteur des puits quantiques est un composé III-V quaternaire.

Selon un mode de réalisation, l'alliage semiconducteur des puits quantiques est du nitrure d'indium-gallium ou du phosphure d'aluminium-indium-gallium.

Selon l'invention, le traitement chimique appliqué à l'étape c) est un traitement par une solution à base d'acide chlorhydrique ou un traitement par une solution à base de sulfure d'ammonium.

Selon un mode de réalisation, à l'étape b), la tranchée est formée par un procédé de gravure sèche.

Selon un mode de réalisation, à l'étape b), la tranchée est formée par gravure RIE ou ICP.

Selon un mode de réalisation, l'étape a) comprend en outre la formation d'une première couche semiconductrice d'un premier type de conductivité, du côté d'une première face de la couche active, et la formation d'une deuxième couche semiconductrice d'un deuxième type de conductivité opposé au premier type de conductivité, du côté d'une deuxième face de la couche active.

Selon un mode de réalisation, la tranchée formée à l'étape b) traverse entièrement la deuxième couche semiconductrice et la couche active, et débouche sur la face supérieure ou dans la première couche semiconductrice.

Selon l'invention, ledit premier composant de l'alliage semiconducteur des puits quantiques est de l'indium.

Un autre mode de réalisation prévoit une diode électroluminescente selon la revendication 11 comprenant une couche active comportant un empilement de puits quantiques multiples, chaque puits quantique comportant une couche en un alliage semiconducteur, dans laquelle la concentration en un premier composant de l'alliage est plus faible dans une partie périphérique de ladite couche que dans une partie centrale de ladite couche.

Selon l'invention, le premier composant de l'alliage semiconducteur des puits quantiques est de l'indium.

Selon un mode de réalisation, la couche active présente, en vue de dessus, une forme générale circulaire.

Selon un mode de réalisation, le nombre de puits quantiques de l'empilement de puits quantiques multiples de la couche active est inférieur ou égal à 10 et de préférence inférieur ou égal à 5.

Selon un mode de réalisation, l'épaisseur de chaque puits quantique de la couche active est inférieure ou égale à 5 nm, et de préférence comprise entre 1 et 3 nm.

### Brève description des dessins

Ces caractéristiques et leurs avantages, ainsi que d'autres, seront exposés en détail dans la description suivante de modes de réalisation particuliers faite à titre non limitatif en relation avec les figures jointes parmi lesquelles :
la figure 1 est une vue en coupe représentant de façon schématique un exemple d'un empilement de LED ;
la figure 2A est une vue en coupe représentant de façon schématique une structure obtenue à l'issue d'une étape d'un procédé de fabrication d'une LED selon un mode de réalisation ;
la figure 2B est une vue en coupe représentant de façon schématique une structure obtenue à l'issue d'une autre étape d'un procédé de fabrication d'une LED selon un mode de réalisation.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. Plus particulièrement, seule une étape liée à la passivation des flancs d'une LED à base de matériaux semiconducteurs inorganiques a été détaillée. Les diverses autres étapes pouvant être mises en œuvre pour réaliser la LED n'ont pas été détaillées, les modes de réalisation décrits étant compatibles avec tous ou la plupart des procédés connus de réalisation de LED à base de matériaux semiconducteurs inorganiques.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

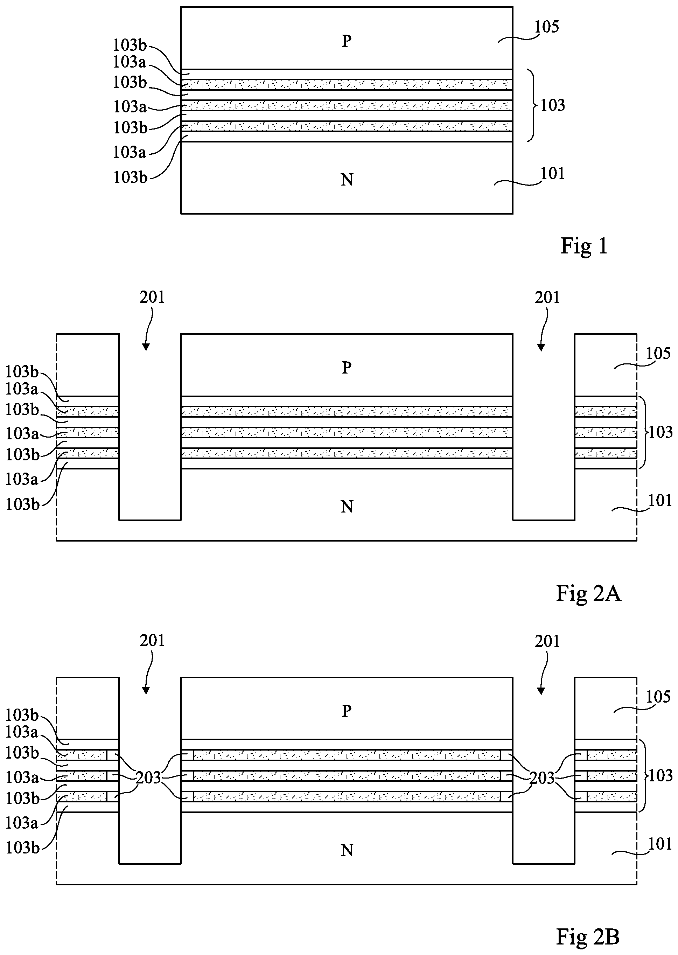

La figure 1 est une vue en coupe représentant de façon schématique un exemple d'un empilement de LED à base de matériaux semiconducteurs inorganiques.

L'empilement de la figure 1 comprend une région 101 en un matériau semiconducteur inorganique dopé de type N, par exemple du nitrure de gallium (GaN) dopé de type N.

L'empilement de la figure 1 comprend en outre une région active 103 à base de matériaux semiconducteurs inorganiques, disposée sur la face supérieure de la région 101, par exemple en contact avec la face supérieure de la région 101. La région active 103 est constituée d'un empilement de puits quantiques multiples. A titre d'exemple, la région active 103 est constituée d'une alternance de couches semiconductrices 103a d'un premier matériau et de couches semiconductrices 103b d'un deuxième matériau, la bande interdite du premier matériau étant plus étroite que celle du deuxième matériau. Chaque couche 103a du premier matériau est prise en sandwich entre deux couches 103b du deuxième matériau et définit un puits quantique. A titre d'exemple, chaque couche 103a du premier matériau est en contact, par sa face inférieure, avec une couche 103b du deuxième matériau et, par sa face supérieure, avec une autre couche 103b du deuxième matériau.

A titre d'exemple, le premier matériau (couches 103a) est un alliage semiconducteur à base d'indium, par exemple du nitrure d'indium-gallium (InGaN). Le deuxième matériau (couches 103b) peut être un alliage semiconducteur ne comportant pas d'indium, par exemple du nitrure de gallium (GaN) ou du nitrure d'aluminium-gallium (AlGaN), ou présentant une concentration d'indium inférieure à celle du premier matériau, par exemple du nitrure d'indium-gallium (InGaN) présentant un taux d'indium inférieur à celui des couches 103a.

L'empilement de la figure 1 comprend en outre une région 105 en un matériau semiconducteur inorganique dopé de type P, par exemple du nitrure de gallium (GaN) dopé de type P, disposée sur la face supérieure de la région active 103, par exemple en contact avec la face supérieure de la région active 103.

Les régions 101 et 105 définissent respectivement une région de cathode et une région d'anode de la LED. Une électrode de cathode (non représentée) en contact avec la région 101 et une électrode d'anode (non représentée) en contact avec la région 105 peuvent être prévues pour polariser la LED. Lorsqu'un courant circule entre la région d'anode 105 et la région de cathode 101 de la LED, des photons sont générés dans la région active 103, notamment à l'intérieur des puits quantiques définis par les couches 103a.

Dans cet exemple, la longueur d'onde d'émission principale de la LED est définie essentiellement par la concentration d'indium dans l'alliage formant les couches 103a.

Pour réaliser une LED du type représenté en figure 1, les régions 101, 103 et 105 peuvent d'abord être déposées sous forme de couches s'étendant de façon continue et sur une épaisseur sensiblement uniforme sur toute la surface d'un substrat de support (non représenté). Des tranchées peuvent ensuite être gravées à travers tout ou partie de l'épaisseur de l'empilement de façon à délimiter latéralement une pluralité de LED élémentaires adressables individuellement. A titre d'exemple, en vue de dessus, les tranchées forment une grille continue délimitant une pluralité d'îlots ou mésas correspondant chacun à une LED élémentaire.

En pratique, on constate que l'efficacité quantique (rapport du nombre de recombinaisons radiatives, c'est-à-dire conduisant à l'émission d'un photon, sur le nombre total de recombinaisons, radiatives ou non radiatives, dans la LED) d'une LED du type décrit ci-dessus diminue lorsque les dimensions latérales de la LED diminuent, et ce tout particulièrement à faible densité de courant, par exemple pour des densités de courant dans la LED inférieures à 40 A/cm².

La diminution d'efficacité quantique observée pour des LED de petites dimensions peut s'expliquer par le fait que la gravure mise en oeuvre pour singulariser les LED, par exemple une gravure sèche, par exemple de type RIE (de l'anglais "Reactive-Ion Etching" - gravure ionique réactive) ou ICP (de l'anglais "Inductively Coupled Plasma" - plasma à couplage inductif), induit inévitablement une dégradation du cristal semiconducteur au voisinage des flancs des LED. Plus les dimensions latérales de la LED sont faibles, plus le volume de matériau semiconducteur impacté par ces dégradations devient significatif devant le volume total de matériau semiconducteur de la LED. Les zones périphériques dégradées par la gravure ayant une efficacité quantique moindre, il en résulte une diminution d'efficacité quantique globalement plus importante pour des LED de petites dimensions que pour des LED de grandes dimensions.

Des études réalisées par les inventeurs ont mis en avant que certains phénomènes de recombinaison parasites (non radiatives ou radiatives à des longueurs d'onde non souhaitées), notamment des recombinaisons de type SRH (de l'anglais "Shockley Read Hall"), liées à l'existence de niveaux énergétiques parasites dans la bande interdite du semiconducteur au voisinage des flancs de la LED, se produisent majoritairement dans les couches de puits quantiques 103a, dans lesquelles les concentrations en porteurs de signes opposés sont les plus élevées.

Selon un aspect des modes de réalisation décrits, on prévoit, après l'étape de gravure des tranchées verticales de singularisation des LED, une étape de traitement chimique des flancs des LED à l'intérieur des tranchées, visant spécifiquement à passiver les flancs des couches de puits quantiques 103a des LED.

Les figures 2A et 2B illustrent des étapes successives d'un exemple d'un procédé de fabrication d'une LED selon un mode de réalisation.

Dans cet exemple, on part d'un empilement comportant, dans l'ordre à partir de la face supérieure d'un substrat de support, non représenté, une couche semiconductrice 101 dopée de type N, une couche active 103, et une couche semiconductrice 105 dopée de type P, tel que décrit ci-dessus en relation avec la figure 1. Les couches 101, 103 et 105 peuvent être formées successivement par épitaxie à partir de la face supérieure d'un substrat de croissance, non représenté.

La figure 2A illustre la structure obtenue à l'issue d'une étape de gravure de tranchées 201 s'étendant verticalement à travers l'empilement, depuis sa face supérieure. Les tranchées 201 délimitent latéralement une ou plusieurs LED élémentaires adressables individuellement. Dans l'exemple représenté, les tranchées 201 traversent entièrement la couche semiconductrice supérieure 105 et la couche active 103, et débouchent dans la couche semiconductrice inférieure 101 sans la traverser entièrement. Autrement dit, dans cet exemple, les LED élémentaires restent reliées électriquement les unes aux autres par leurs régions de cathode. Les modes de réalisation décrits ne se limitent toutefois pas à cet exemple particulier.

Les tranchées 201 peuvent être formées par gravure RIE, par gravure ICP, ou par tout autre procédé de gravure adapté. Avant l'étape de gravure proprement dite, un masque, non représenté, peut être disposé du côté de la face supérieure de la couche 105 pour délimiter latéralement les tranchées 201.

La figure 2B illustre de façon schématique la structure obtenue à l'issue d'une étape de traitement chimique des flancs des couches de puits quantiques 103a exposés au niveau des parois latérales des tranchées 201.

Lors de cette étape, un traitement chimique adapté à graver sélectivement l'indium de l'alliage semiconducteur des couches 103a par rapport à au moins un autre composant de cet alliage est appliqué sur les flancs de l'empilement de LED au niveau des parois latérales des tranchées 201. Le traitement chimique peut être appliqué par voie humide ou par voie gazeuse.

A titre d'exemple, les couches 103a sont en nitrure d'indium-gallium avec une proportion d'indium choisie en fonction de la longueur d'onde d'émission souhaitée, et le traitement appliqué est choisi adapté à graver sélectivement l'indium par rapport au gallium et/ou à l'azote de l'alliage. Par gravure sélective, on entend ici que le traitement appliqué est adapté à graver l'indium plus rapidement que le gallium et/ou l'azote de l'alliage.

Le traitement utilisé est une solution à base d'acide chlorhydrique (HCl) ou une solution à base de sulfure d'ammonium (NH₄)₂S, qui présentent l'avantage de graver sélectivement l'indium par rapport au gallium. A titre de variante, un premier traitement par une solution à base d'acide chlorhydrique est appliqué, suivi d'un deuxième traitement par une solution à base de sulfure d'ammonium, ou inversement.

A titre d'exemple (non limitatif), la gravure est mise en œuvre dans un bain d'une solution d'acide chlorhydrique (HCl) à 37 % diluée dans de l'eau déionisée à hauteur d'un volume de solution d'acide chlorhydrique pour neuf volumes d'eau déionisée, pendant environ 10 minutes, à température ambiante.

A titre de variante (non limitative), la gravure est mise en œuvre dans un bain de sulfure d'ammonium (NH₄)₂S à 20 %, pendant 5 à 30 minutes, à température ambiante.

A l'issue de cette étape, une portion périphérique 203 de chaque couche 103a de la LED, s'étendant latéralement depuis le flanc de la LED en direction du centre de la LED, présente une concentration en indium inférieure à la concentration en indium initiale de la couche 103a. La concentration en indium des couches 103a reste en revanche inchangée en partie centrale de la LED. A titre d'exemple, à l'issue de l'étape de gravure, la concentration en indium dans la partie périphérique 203 de la couche 103a est inférieure d'au moins 20 % et de préférence d'au moins 50 % à la concentration en indium dans une partie centrale de la couche 103a.

On notera que dans la mesure où l'indium est gravé de façon sélective par rapport à au moins un autre composant de l'alliage semiconducteur constituant les couches de puits quantiques 103a, les flancs des portions 203 côté tranchées 201 peuvent en pratique rester physiquement alignés avec les flancs des autres couches de l'empilement à l'issue du traitement, tel que représenté sur la figure 2B.

Dans le cas où les couches 103a sont en nitrure d'indium-gallium (InGaN), lors de la gravure, les portions périphériques 203 des couches 103a sont transformées en nitrure de gallium (GaN) ou en nitrure d'indium-gallium présentant une concentration en indium inférieure à la concentration initiale.

La profondeur (dimension latérale) de gravure de l'indium dépend du temps de gravure et de la concentration de la solution utilisée. Cette profondeur reste toutefois limitée par la compacité de l'alliage semiconducteur cristallin constituant les couches 103a, ne permettant pas une pénétration profonde de la solution de gravure. A titre d'exemple, la profondeur impactée par la gravure (dimension latérale des régions 203) est comprise entre 1 et 50 nm, par exemple entre 1 et 15 nm.

La gravure sélective de l'indium des couches 103a en périphérie de l'empilement de LED permet avantageusement d'élargir la bande interdite des couches 103a au voisinage des flancs de la LED. Ceci conduit les porteurs de charges à se détourner au moins partiellement de cette zone, et par conséquent à rester éloignés de la zone potentiellement dégradée lors de la gravure des tranchées 201, et susceptible de comporter des niveaux d'énergie parasites.

Les études menées par les inventeurs ont montré que ce traitement permet de réduire significativement les recombinaisons parasites au voisinage des flancs de la LED, et ainsi d'accroître sensiblement l'efficacité quantique, notamment pour des LED de faibles dimensions latérales, par exemple de dimensions latérales inférieures à 10 µm.

Le traitement proposé peut s'inscrire dans un procédé de passivation des flancs d'un empilement de LED pouvant comprendre d'autres étapes, par exemple d'autres traitements chimiques et/ou thermiques, et/ou un dépôt d'un matériau diélectrique de passivation sur les flancs de l'empilement.

Pour améliorer davantage l'efficacité quantique, on pourra avantageusement réaliser une LED présentant, en vue de dessus, une forme géométrique conduisant à limiter le périmètre de la LED pour une surface donnée, par exemple une forme circulaire. Ceci permet de limiter le volume de matériau semiconducteur dégradé lors de la gravure des tranchées 201, devant le volume total de matériau semiconducteur de la LED.

Par ailleurs, pour limiter la formation de niveaux énergétiques parasites au voisinage des flancs des couches 103, on pourra avantageusement prévoir de limiter l'épaisseur de couches de puits quantiques 103a et/ou le nombre de puits quantiques 103a. A titre d'exemple, on pourra prévoir un nombre de puits quantiques 103a inférieur ou égal à 10 et de préférence inférieur ou égal à 5. Par ailleurs on pourra prévoir une épaisseur de chaque puits quantique 103a inférieure ou égale à 5 nm, par exemple comprise entre 1 et 3 nm. Les modes de réalisation décrits ne se limitent toutefois pas à ces exemples particuliers.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, les modes de réalisation décrits ne se limitent pas aux exemples de matériaux décrits ci-dessus. Plus particulièrement, les modes de réalisation décrits ne se limitent pas à l'exemple décrit ci-dessus dans lequel les puits quantiques 103a sont en nitrure d'indium-gallium (InGaN). Plus généralement, les modes de réalisation décrits s'appliquent quel que soit la composition de l'alliage semiconducteur cristallin formant les couches de puits quantiques 103a, pour autant que cet alliage comporte de l'indium et que la proportion d'indium dans l'alliage détermine la largeur de la bande interdite de l'alliage, et donc la longueur d'onde d'émission de la LED. A titre d'exemple, le matériau des couches de puits quantiques peut être du phosphure d'aluminium-indium-gallium (AlInGaP), ou, plus généralement, tout composé III-V, par exemple ternaire ou quaternaire, comportant de l'indium et dans lequel la largeur de bande interdite est fonction de la concentration en indium de l'alliage.

Plus généralement, la solution proposée pourra être adaptée à tout alliage semiconducteur susceptible d'être utilisé pour réaliser des puits quantiques d'une diode électroluminescente à puits quantiques multiples.

Cependant, les modes de réalisation faisant partie de l'invention se limitent à la gravure sélective de l'indium. Plus généralement, quelle que soit la composition de l'alliage semiconducteur formant les puits quantiques multiples, on choisira un traitement adapté à graver sélectivement un premier composant de l'alliage par rapport à au moins un autre composant de l'alliage, le premier composant étant choisi tel que la largeur de bande interdite de l'alliage soit fonction de la concentration du premier composant dans l'alliage.

A titre d'exemple, l'alliage semiconducteur formant les puits quantiques peut être un composé III-V ternaire, par exemple un composé du groupe comprenant :
- l'arséniure de gallium-aluminium (AlGaAs, AlₓGa₁₋ₓAs) ;
- l'arséniure de gallium-indium (InGaAs, InₓGa₁₋ₓAs) ;
- le phosphure de gallium-indium (InGaP) ;
- l'arséniure d'aluminium-indium (AlInAs) ;
- l'antimoniure d'aluminium-indium (AlInSb) ;
- l'arséniure-nitrure de gallium (GaAsN) ;
- l'arséniure-phosphure de gallium (GaAsP) ;
- le nitrure d'aluminium-gallium (AlGaN) ;
- le phosphure de gallium-aluminium (AlGaP) ;
- le nitrure de gallium-indium (InGaN) ;
- l'arséniure-antimoniure d'indium (InAsSb) ; et
- l'antimoniure de gallium-indium (InGaSb).

On notera que seul les alliages ci-dessus contenant de l'indium font partie de la présente invention.

A titre de variante, l'alliage semiconducteur formant les puits quantiques peut être un composé III-V quaternaire, par exemple un composé du groupe comprenant :
- le phosphure de gallium-indium-aluminium (AlGaInP, ou InAlGaP, InGaAlP, AlInGaP) ;
- l'arséniure-phosphure de gallium-aluminium (AlGaAsP) ;
- l'arséniure-phosphure de gallium-indium (InGaAsP) ;
- l'arséniure-phosphure d'aluminium-indium (AlInAsP) ;
- l'arséniure-nitrure de gallium-aluminium (AlGaAsN) ;
- l'arséniure-nitrure de gallium-indium (InGaAsN) ;
- l'arséniure-nitrure d'aluminium-indium (InAlAsN) ; et
- l'arséniure-antimoniure-nitrure de gallium (GaAsSbN).

On notera que seul les alliages ci-dessus contenant de l'indium font partie de la présente invention.

A titre de variante, l'alliage semiconducteur formant les puits quantiques peut être un composé III-V quinaire, par exemple un composé du groupe comprenant :
- l'arséniure-antimoniure-nitrure de gallium-indium (GaInNAsSb) ; et
- l'arséniure-antimoniure-phosphure de gallium-indium (GaInAsSbP).

A titre de variante, l'alliage semiconducteur formant les puits quantiques peut être un composé II-VI binaire, par exemple un composé du groupe comprenant :
- le sulfure de cadmium (CdS) ;
- le séléniure de cadmium (CdSe) ;
- le tellurure de cadmium (CdTe) ;
- le sulfure de mercure (HgS) ;
- le tellurure de mercure (HgTe) ;
- l'oxyde de zinc (ZnO) ;
- le sulfure de zinc (ZnS) ;
- le séléniure de zinc (ZnSe) ; et
- le tellurure de zinc (ZnTe).

Ces alliages ne font cependant pas partie de l'invention.

A titre de variante, l'alliage semiconducteur formant les puits quantiques peut être un composé II-VI ternaire, par exemple un composé du groupe comprenant :
- le tellurure de zinc-cadmium (CdZnTe, CZT) ;
- le tellurure de mercure-cadmium (HgCdTe, MCT) ;
- le tellurure de mercure-zinc (HgZnTe, MZT) ; et
- le séléniure de zinc-mercure (HgZnSe).

Ces alliages ne font cependant pas partie de l'invention.

A titre de variante, l'alliage semiconducteur formant les puits quantiques peut être un composé IV-IV ne faisant pas partie de l'invention, par exemple du silicium-germanium (SiGe).

## Revendications

1. Procédé de fabrication d'une diode électroluminescente, comprenant les étapes successives suivantes :
a) former une couche active (103) comportant un empilement de puits quantiques multiples, chaque puits quantique comportant une couche (103a) en un alliage semiconducteur ;
b) former une tranchée (201) de singularisation de la diode, ladite tranchée traversant la couche active (103) ; et
c) appliquer sur les flancs de la couche active (103), au niveau des parois latérales de la tranchée (201), un traitement chimique adapté à graver un premier composant de l'alliage semiconducteur sélectivement par rapport à au moins un autre composant de l'alliage semiconducteur, dans lequel la largeur de bande interdite de l'alliage semiconducteur est fonction de la concentration du premier composant dans l'alliage, ledit premier composant de l'alliage semiconducteur étant de l'indium (In),
**caractérisé en ce que** le traitement chimique appliqué à l'étape c) est un traitement par une solution à base d'acide chlorhydrique ou un traitement par une solution à base de sulfure d'ammonium et résulte en une concentration du premier composant de l'alliage semiconducteur plus faible dans une partie périphérique (203) de chaque couche (103a) de l'empilement de puits quantique, que dans une partie centrale de ladite couche (103a).

2. Procédé selon la revendication 1, dans lequel la largeur de bande interdite de l'alliage semiconducteur est d'autant plus élevée que la concentration du premier composant dans l'alliage est faible.

3. Procédé selon la revendication 1 ou 2, dans lequel l'alliage semiconducteur des puits quantiques (103a) est un composé III-V ternaire.

4. Procédé selon la revendication 1 ou 2, dans lequel l'alliage semiconducteur des puits quantiques (103a) est un composé III-V quaternaire.

5. Procédé selon l'une quelconque des revendications 1 à 4, dans lequel l'alliage semiconducteur des puits quantiques (103a) est du nitrure d'indium-gallium ou du phosphure d'aluminium-indium-gallium.

6. Procédé selon l'une quelconque des revendications 1 à 5, dans lequel, à l'étape b), la tranchée (201) est formée par un procédé de gravure sèche.

7. Procédé selon l'une quelconque des revendications 1 à 6, dans lequel, à l'étape b), la tranchée (201) est formée par gravure RIE ou ICP.

8. Procédé selon l'une quelconque des revendication 1 à 7, dans lequel l'étape a) comprend en outre la formation d'une première couche semiconductrice (101) d'un premier type de conductivité, du côté d'une première face de la couche active (103), et la formation d'une deuxième couche semiconductrice (105) d'un deuxième type de conductivité opposé au premier type de conductivité, du côté d'une deuxième face de la couche active (103).

9. Procédé selon la revendication 8, dans lequel la tranchée (201) formée à l'étape b) traverse entièrement la deuxième couche semiconductrice (105) et la couche active (103), et débouche sur la face supérieure ou dans la première couche semiconductrice (101).

10. Diode électroluminescente comprenant une couche active (103) comportant un empilement de puits quantiques multiples, chaque puits quantique comportant une couche (103a) en un alliage semiconducteur, la diode étant réalisée par un procédé selon l'une quelconque des revendications 1 à 9, d'où il résulte que la concentration
en un premier composant de l'alliage est plus faible dans une partie périphérique (203) de ladite couche (103a) que dans une partie centrale de ladite couche (103a), et
dans laquelle ledit premier composant de l'alliage semiconducteur des puits quantiques est de l'indium.

11. Diode selon la revendication 10, dans laquelle la couche active (103) présente, en vue de dessus, une forme générale circulaire.

12. Diode selon l'une quelconque des revendications 10 ou 11, dans laquelle le nombre de puits quantiques de l'empilement de puits quantiques multiples de la couche active (103) est inférieur ou égal à 10 et de préférence inférieur ou égal à 5.

13. Diode selon l'une quelconque des revendications 10 à 12, dans laquelle l'épaisseur de chaque puits quantique de la couche active (103) est inférieure ou égale à 5 nm, et de préférence comprise entre 1 et 3 nm.

## Patentansprüche

1. Ein Verfahren zur Herstellung einer lichtemittierenden Diode, das die aufeinanderfolgenden Schritte aufweist:
a) Ausbilden einer aktiven Schicht (103), die einen Stapel aus mehreren Quantentöpfen aufweist, wobei jeder Quantentopf eine Schicht (103a) aufweist, die aus einer Halbleiterlegierung besteht;
b) Ausbilden eines Grabens (201) zum Vereinzeln der Diode, wobei der Graben die aktive Schicht (103) durchquert; und
c) Aufbringen einer chemischen Behandlung auf die Seitenflächen der aktiven Schicht (103) in Höhe der Seitenwände des Grabens (201), mit der eine erste Komponente der Halbleiterlegierung selektiv gegenüber mindestens einer anderen Komponente der Halbleiterlegierung geätzt werden kann, wobei die Bandlückenbreite der Halbleiterlegierung eine Funktion der Konzentration der ersten Komponente in der Legierung ist und die erste Komponente der Legierung Indium (In) ist,
**dadurch gekennzeichnet, dass** die in Schritt c) angewendete chemische Behandlung eine Behandlung mit einer Salzsäurelösung oder eine Behandlung mit einer Ammoniumsulfidlösung ist und zu einer Konzentration der ersten Komponente der Halbleiterlegierung führt, die in einem peripheren Abschnitt (203) jeder Schicht (103a) des Stapels aus mehreren Quantentöpfen niedriger ist als in einem zentralen Abschnitt der Schicht (103a).

2. Das Verfahren nach Anspruch 1, wobei die Bandlückenbreite der Halbleiterlegierung umso größer ist, je niedriger die Konzentration der ersten Komponente in der Legierung ist.

3. Das Verfahren nach Anspruch 1 oder 2, wobei die Halbleiterlegierung der Quantentöpfe (103a) eine III-V-Ternärverbindung ist.

4. Das Verfahren nach Anspruch 1 oder 2, wobei die Halbleiterlegierung der Quantentöpfe (103a) eine III-V-Quaternärverbindung ist.

5. Das Verfahren nach einem der Ansprüche 1 bis 4, wobei die Halbleiterlegierung der Quantentöpfe (103a) Indium-Gallium-Nitrid oder Aluminium-Indium-Gallium-Phosphid ist.

6. Das Verfahren nach einem der Ansprüche 1 bis 5, wobei in Schritt b) der Graben (201) durch ein Trockenätzverfahren ausgebildet wird.

7. Das Verfahren nach einem der Ansprüche 1 bis 6, wobei in Schritt b) der Graben (201) durch RIE- oder ICP-Ätzen ausgebildet wird.

8. Das Verfahren nach einem der Ansprüche 1 bis 7, wobei Schritt a) ferner das Ausbilden einer ersten Halbleiterschicht (101) eines ersten Leitfähigkeitstyps auf der Seite einer ersten Oberfläche der aktiven Schicht (103) und das Ausbilden einer zweiten Halbleiterschicht (105) eines zweiten Leitfähigkeitstyps, der dem ersten Leitfähigkeitstyp entgegengesetzt ist, auf der Seite einer zweiten Oberfläche der aktiven Schicht (103) aufweist.

9. Das Verfahren nach Anspruch 8, wobei der in Schritt b) ausgebildete Graben (201) die zweite Halbleiterschicht (105) und die aktive Schicht (103) vollständig durchquert und auf der oberen Oberfläche oder in die erste Halbleiterschicht (101) mündet.

10. Eine lichtemittierende Diode, die eine aktive Schicht (103) aufweist, die einen Stapel aus mehreren Quantentöpfen aufweist, wobei jeder Quantentopf eine Schicht (103a) aufweist, die aus einer Halbleiterlegierung besteht, wobei die Diode durch ein Verfahren nach einem der Ansprüche 1 bis 9 hergestellt wird, was zu einer Konzentration einer ersten Komponente der Legierung führt, die in einem peripheren Abschnitt (203) der Schicht (103a) niedriger ist als in einem zentralen Abschnitt der Schicht (103a), und wobei die erste Komponente der Halbleiterlegierung der Quantentöpfe Indium ist.

11. Die Diode nach Anspruch 10, wobei die aktive Schicht (103) in Draufsicht eine im Wesentlichen kreisförmige Form aufweist.

12. Die Diode nach Anspruch 10 oder 11, wobei die Anzahl der Quantentöpfe des Stapels aus mehreren Quantentöpfen der aktiven Schicht (103) kleiner als oder gleich 10 und vorzugsweise kleiner als oder gleich 5 ist.

13. Die Diode nach einem der Ansprüche 10 bis 12, wobei die Dicke jedes Quantentopfs der aktiven Schicht (103) kleiner als oder gleich 5 nm ist und vorzugsweise im Bereich von 1 bis 3 nm liegt.

## Claims

1. A light-emitting diode manufacturing method, comprising the successive steps of:
a) forming an active layer (103) comprising a stack of multiple quantum wells, each quantum well comprising a layer (103a) made of a semiconductor alloy;
b) forming a trench (201) for singularizing the diode, said trench crossing the active layer (103); and
c) applying to the sides of the active layer (103), at the level of the lateral walls of the trench (201), a chemical treatment capable of etching a first component of the semiconductor alloy selectively over at least another component of the semiconductor alloy, wherein the bandgap width of the semiconductor alloy is a function of the concentration of the first component in the alloy, said first component of the alloy being Indium (In),
**characterized in that** the chemical treatment applied at step c) is a treatment with a hydrochloric acid solution or a treatment with an ammonium sulfide solution and results in a concentration of the first component of the semiconductor alloy lower in a peripheral part (203) of each layer (103a) of the stack of multiple quantum wells, than in a central part of said layer (103a).

2. The method according to claim 1, wherein the bandgap width of the semiconductor alloy is all the larger as the concentration of the first component in the alloy is low.

3. The method according to claim 1 or 2, wherein the semiconductor alloy of the quantum wells (103a) is a ternary III-V compound.

4. The method according to claim 1 or 2, wherein the semiconductor alloy of the quantum wells (103a) is a quaternary III-V compound.

5. The method according to any of claims 1 to 4, wherein the semiconductor alloy of the quantum wells (103a) is indium gallium nitride or aluminum indium gallium phosphide.

6. The method according to any of claims 1 to 5, wherein at step b), the trench (201) is formed by a dry etching method.

7. The method according to any of claims 1 to 6, wherein, at step b), the trench (201) is formed by RIE or ICP etching.

8. The method according to any of claims 1 to 7, wherein step a) further comprises the forming of a first semiconductor layer (101) of a first conductivity type, on the side of a first surface of the active layer (103), and the forming of a second semiconductor layer (105) of a second conductivity type opposite to the first conductivity type, on the side of a second surface of the active layer (103).

9. The method according to claim 8, wherein the trench (201) formed at step b) thoroughly crosses the second semiconductor layer (105) and the active layer (103), and emerges onto the upper surface or into the first semiconductor layer (101).

10. A light-emitting diode comprising an active layer (103) comprising a stack of multiple quantum wells, each quantum well comprising a layer (103a) made of a semiconductor alloy, the diode being realized by a method according to any of claims 1 to 9, resulting in the concentration of a first component of the alloy being lower in a peripheral portion (203) of said layer (103a) than in a central portion of said layer (103a), and wherein said first component of the semiconductor alloy of the quantum wells is indium.

11. The diode according to claim 10, wherein the active layer (103) has, in top view, a generally circular shape.

12. The diode according to claim 10 or 11, wherein the number of quantum wells of the stack of multiple quantum wells of the active layer (103) is smaller than or equal to 10 and preferably smaller than or equal to 5.

13. The diode according to any of claims 10 to 12, wherein the thickness of each quantum well of the active layer (103) is smaller than or equal to 5 nm, and preferably in the range from 1 to 3 nm.
